# EUROPEAN PATENT APPLICATION

(11) **EP 2 840 709 A1**
(43) Date of publication of application: **25.02.2015**
(21) Application number: 13181370.1
(22) Date of filing: 22.08.2013
(51) Int. Cl.: H03F 1/02, H03F 3/195, H03F 3/21, H03F 3/24, H03F 3/72

(54) **Amplifier and method of amplification**

(71) Applicant: Telefonaktiebolaget L M Ericsson (publ), 164 83 Stockholm (SE)
(72) Inventor: Brandt, Per-Olof, 231 34 Lomma (SE)
(74) Representative: Gray, Peter John Bracey

(57) **Abstract**

An amplifier (200) comprises an envelope generation stage (10) arranged to generate a first envelope signal indicative of an envelope of an input signal over a first range of values of the envelope of the input signal, and a second envelope signal indicative of the envelope of the input signal over a second range, higher than the first range, of values of the envelope of the input signal. The first envelope signal is substantially independent of the envelope of the input signal over the second range, and the second envelope signal is substantially independent of the envelope of the input signal over the first range. A first amplification stage (50) is arranged to amplify the input signal and has a first supply of power dependent on the first envelope signal. A second amplification stage (60) is arranged to amplify the input signal and has a second supply of power dependent on the second envelope signal. A summing stage (80) is arranged to sum the input signal amplified by the first and second amplification stages (50, 60).

## Description

### Field of the Disclosure

The present disclosure relates to an amplifier, an electronic device comprising the amplifier, a wireless communication apparatus comprising the electronic device, and a method of amplification. The disclosure has application in, particularly but not exclusively, a power amplifier for a mobile phone.

### Background to the Disclosure

A power amplifier for a mobile phone is required to deliver a variable output power. The efficiency of the power amplifier is commonly optimised at a particular output power level, and when the output power deviates from this level, the efficiency or linearity of the power amplifier drops, causing a non-optimum power consumption or a degradation in system performance. The current drain for the top 10dB of output power from a mobile phone is of increasing importance in mobile phone design, and simultaneously modulation schemes are being introduced which lead to higher peak-to-average ratios (PAR). Envelope tracking using a time-varying power supply to an amplifier is a known technique for improving the power efficiency of an amplifier. There is a requirement for an improved amplifier and method of amplification.

### Summary of the Preferred Embodiments

According to a first aspect there is provided an amplifier comprising:
an envelope generation stage arranged to generate first and second envelope signals in response to an input signal;
wherein the first envelope signal is indicative of an envelope of the input signal over a first range of values of the envelope of the input signal and is substantially independent of the envelope of the input signal over a second range, higher than the first range, of values of the envelope of the input signal;
wherein the second envelope signal is indicative of the envelope of the input signal over the second range of values of the envelope of the input signal is substantially independent of the envelope of the input signal over the first range of values of the envelope of the input signal;
a first amplification stage arranged to amplify the input signal and having a first supply of power dependent on the first envelope signal;
a second amplification stage arranged to amplify the input signal and having a second supply of power dependent on the second envelope signal; and
a summing stage arranged to sum the input signal amplified by the first and second amplification stages.

According to a second aspect there is provided a method of amplification, comprising:
generating first and second envelope signals in response to an input signal;
wherein the first envelope signal is indicative of an envelope of the input signal over a first range of values of the envelope of the input signal and is substantially independent of the envelope of the input signal over a second range, higher than the first range, of values of the envelope of the input signal;
wherein the second envelope signal is indicative of the envelope of the input signal over the second range of values of the envelope of the input signal and is substantially independent of the envelope of the input signal over the first range of values of the envelope of the input signal;
amplifying, dependent on the first envelope signal, the input signal in a first amplification stage whilst supplying to the first amplification stage first power dependent on the first envelope signal;
amplifying, dependent on the second envelope signal, the input signal in a second amplification stage whilst supplying to the second amplification stage second power dependent on the second envelope signal; and
summing the input signal amplified by the first and second amplification stages.

Therefore, at relatively low values of the envelope of the input signal, the first amplification stage may be arranged to amplify the input signal in an envelope tracking mode by using a variable supply of power dependent on the envelope of the input signal, and the second amplification stage need not provide amplification and may have low power consumption. At higher values of the envelope of the input signal, the first amplification stage may amplify the input signal without using envelope tracking, for example by using a constant supply of power, and the second amplification stage may be arranged to amplify the input signal in an envelope tracking mode by using a variable supply of power dependent on the envelope of the input signal.

The first envelope signal may be related linearly to the envelope of the input signal over the first range. The second envelope signal may be related linearly to the envelope of the input signal over the second range. These features enable precise envelope tracking, and therefore highly linear amplification and high power efficiency.

Over the second range, the first envelope signal may exceed ninety percent of a maximum value of the first envelope signal. Over the first range, the second envelope signal may be less than ten percent of a maximum value of the second envelope signal. These features enable high power efficiency.

The first and second ranges of values of the envelope of the input signal may be spaced apart by a first gap of width less than ten percent of the first range. This feature enables simple implementation by providing for a transition of the first and second envelope signals in the first gap between the first and second ranges of values of the envelope of the input signal.

In one embodiment of the amplifier, the envelope generation stage may be arranged to generate a third envelope signal in response to the input signal;
wherein the third envelope signal is indicative of the envelope of the input signal over a third range, higher than the second range, of values of the envelope of the input signal, and is substantially independent of the envelope of the input signal over the first and second ranges of values of the envelope of the input signal;
wherein the first and second envelope signals are substantially independent of the envelope of the input signal over the third range; and
the amplifier may comprise a third amplification stage arranged to amplify the input signal and having a third supply of power dependent on the third envelope signal; and
the summing stage may be arranged to sum the input signal amplified by the first, second and third amplification stages.

Likewise, one embodiment of the method of amplification may comprise:
generating a third envelope signal in response to the input signal;
wherein the third envelope signal is indicative of the envelope of the input signal over a third range, higher than the second range, of values of the envelope of the input signal and is substantially independent of the envelope of the input signal over the first and second ranges of values of the envelope of the input signal;
wherein the first and second envelope signals are substantially independent of the envelope of the input signal over the third range; and
amplifying, dependent on the third envelope signal, the input signal in a third amplification stage whilst supplying to the third amplification stage third power dependent on the third envelope signal; and
summing the input signal amplified by the first, second and third amplification stages.

These features enable high power efficiency.

The third envelope signal may be related linearly to the envelope of the input signal over the third range. This feature enables precise envelope tracking, and therefore highly linear amplification and high power efficiency.

Over the third range, the first envelope signal may exceed ninety percent of the maximum value of the first envelope signal and the second envelope signal may exceed ninety percent of a maximum value of the second envelope signal. Over the first and second ranges, the third envelope signal may be less than ten percent of a maximum value of the third envelope signal. These features enable high power efficiency.

The second and third ranges of values of the envelope of the input signal may be spaced apart by a second gap of width less than ten percent of the second range. This feature enables simple implementation by providing for a transition of the second and third envelope signals in the second gap between the second and third ranges of values of the envelope of the input signal.

There is also provided an electronic device comprising an amplifier according to the first aspect. The electronic device may be, for example, an integrated circuit.

There is also provides a mobile communication device comprising an amplifier according to the first aspect.

### Brief Description of the Drawings

Preferred embodiments will now be described, by way of example only, with reference to the accompanying drawings, in which:
Figure 1 is a schematic diagram of an amplifier;
Figure 2 is a graph of a first envelope signal as a function of input signal amplitude;
Figure 3 is a graph of a second envelope signal as a function of input signal amplitude;
Figure 4 is a graph of output signal amplitude as a function of input signal amplitude of the amplifier of Figure 1;
Figure 5 is a schematic diagram of another embodiment of an amplifier;
Figure 6 is a graph of the second envelope signal as a function of input signal amplitude of the amplifier of Figure 5;
Figure 7 is a graph of a third envelope signal as a function of input signal amplitude;
Figure 8 is a graph of output signal amplitude as a function of input signal amplitude of the amplifier of Figure 5;
Figure 9 is a graph of first, second and third envelope signals as a function of input signal amplitude;
Figure 10 is a graph of power efficiency of first, second and third amplification stages of an amplifier;
Figure 11 is flow chart of a method of amplification; and
Figure 12 is a schematic diagram of a wireless communication device.

### Detailed Description of Preferred Embodiments

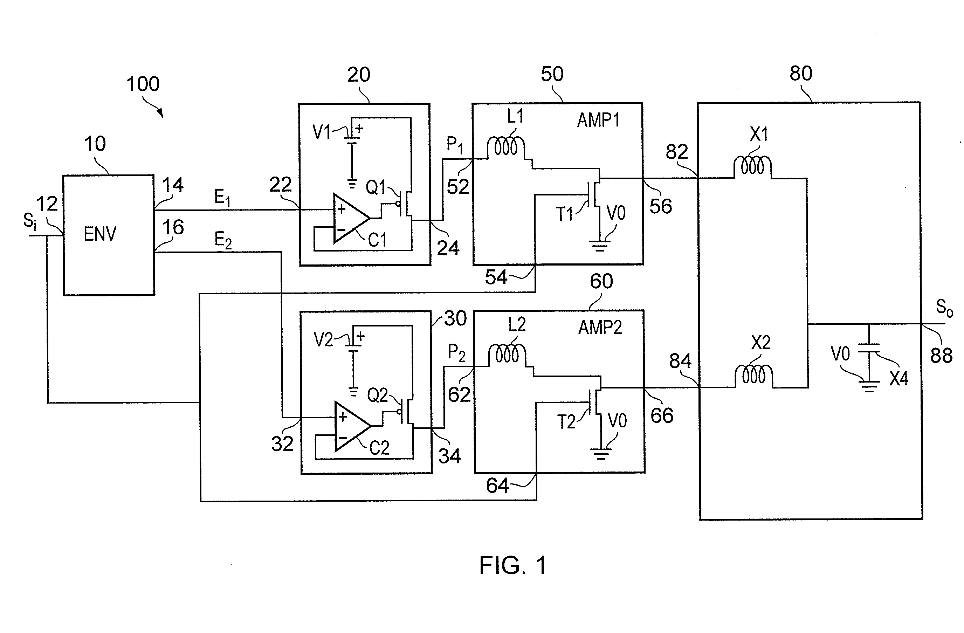

Referring to Figure 1, an amplifier 100 comprises an envelope generation stage (ENV) 10 having an input 12 for an input signal Sᵢ to be amplified. The envelope generation stage 10 is arranged to generate a first envelope signal E₁ and a second envelope signal E₂ in response to the input signal Sᵢ. The envelope generation stage 10 delivers the first envelope signal E₁ at a first output 14, and the second envelope signal E₂ at a second output 16. The amplitude of the input signal Sᵢ can vary with time due to amplitude modulation, and the term envelope refers to the variation of the amplitude. Therefore, a reference to a value of the envelope means a value of the amplitude, or more specifically a value of the time-varying amplitude. For conciseness, a value of the envelope is alternatively referred to simply as the envelope or amplitude.

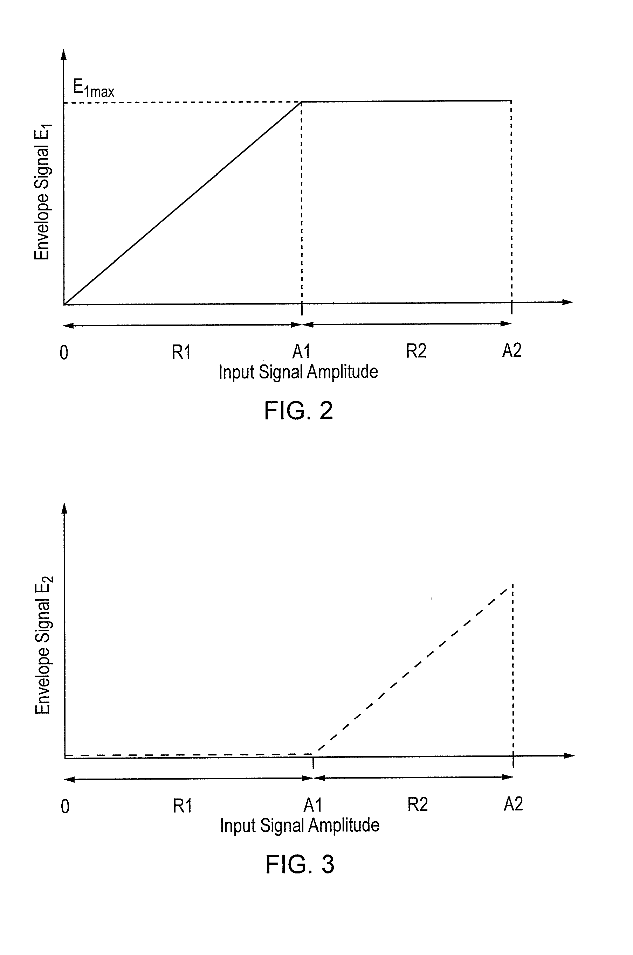

Referring to Figure 2, the first envelope signal E₁ is related linearly to an envelope of the input signal Sᵢ over a first range R1 of values, 0<R1 ≤A1, of the envelope of the input signal Sᵢ. Such a linear relationship may be represented in the form E₁=a.E(Sᵢ)+b, where a is a first constant, b is a second constant, and E(Sᵢ) is the envelope of the input signal Sᵢ. The first envelope signal E₁ is substantially independent of the envelope of the input signal over a second range R2 of values, A1 <R2≤A2, of the envelope of the input signal, where the second range R2 is higher than the first range R1. Therefore, the first range R1 is greater than zero, and less than or equal to a value A1, and the second range R2 is greater than a value A1, and less than or equal to a value A2. The first envelope signal E₁ may be zero when the input signal envelope is zero, in which case the first envelope signal E₁ may be proportional to the envelope of the input signal Sᵢ over the first range R1, corresponding to the second constant b having a value zero. Alternatively, the first envelope signal E₁ may have a low non-zero value of b when the input signal envelope is zero, typically sufficient for ensuring biasing of a first amplification stage, referenced 50 in Figure 1 and described below. Over the second range R2 of values of the input signal envelope, the first envelope signal E₁ may be constant at a value E₁ₘₐₓ, as illustrated in the example of Figure 2, where E₁ₘₐₓ is the maximum value of the first envelope signal E₁ that is, or can be, provided, but in other examples the first envelope signal E₁ may have a lower value than E₁ₘₐₓ over the second range R2. Preferably , over the second range R2 of values of the input signal envelope, the first envelope signal E₁ exceeds ninety percent of the value E₁ₘₐₓ. Also, preferably, over the second range R2 of values of the input signal envelope the first envelope signal E₁ is substantially constant.

Referring to Figure 3, the second envelope signal E₂ is substantially independent of the envelope of the input signal Sᵢ over the first range R1 of values of the input signal envelope, which is lower than the second range R2, and is related linearly to the envelope of the input signal Sᵢ over the second range R2 of values of the envelope of the input signal Sᵢ. Over the first range R1 of values of the input signal envelope, the second envelope signal E₂ may be zero, in which case the second envelope signal E₂ may be proportional to the envelope of the input signal Sᵢ over the second range R2. Alternatively, over the first range R1 the second envelope signal E₂ may have a low value, typically sufficient for ensuring biasing of a second amplification stage, referenced 60 in Figure 1 and described below. Preferably, over the first range R1, the second envelope signal E₂ may have a value less than ten percent of a maximum value E₂ₘₐₓ of the second envelope signal E₂, where E₂ₘₐₓ is the maximum value of the second envelope signal E₂ that is, or can be, provided. Also, preferably, over the first range R1 of values of the input signal envelope the second envelope signal E₂ is substantially constant.

Reverting to Figure 1, the first output 14 of the envelope generation stage 10 is coupled to an input 22 of a first power supply stage 20 which may be a voltage regulator, as illustrated in Figure 1, but alternatively may be a current regulator. In the example of Figure 1, the first power supply stage 20 is a voltage regulator and comprises a first comparator C1 having a non-inverting input coupled to the input 22 of the first power supply stage 20, an inverting input coupled to a drain of a first regulator transistor Q1, and an output coupled to a gate of the first regulator transistor Q1. A source of the first regulator transistor Q1 is coupled to a first voltage rail V1. The drain of the first regulator transistor Q1 is also coupled to an output 24 of the first power supply stage 20, for delivering a first power P₁ dependent on the first envelope signal E₁.

A first amplification stage (AMP1) 50 is arranged to amplify the input signal Sᵢ using the first power P₁ as a first supply of power dependent on the first envelope signal E₁. The first amplification stage 50 comprises a first input 52 coupled the output 24 of the first power supply stage 20 for receiving the first power P₁. The first amplification stage 50 also comprises a first inductive element L1 coupled between the first input 52 of the first amplification stage 50 and a drain of a first amplification transistor T1. The first amplification transistor T1 has a gate coupled to a second input 54 of the first amplification stage 50, which is coupled to the input 12 of the envelope generation stage 10 for receiving the input signal Sᵢ, and a source coupled to a reference voltage rail V0 that in this example is a ground. The drain of the first amplification transistor T1 is coupled to an output 56 of the first amplification stage 50 for delivering the input signal Sᵢ amplified by the first amplification stage 50.

The second output 16 of the envelope generation stage 10 is coupled to an input 32 of a second power supply stage 30 which may be a voltage regulator, as illustrated in Figure 1, but alternatively may be a current regulator. In the example of Figure 1, the second power supply stage 30 is a voltage regulator and comprises a second comparator C2 having a non-inverting input coupled to the input 32 of the second power supply stage 30, an inverting input coupled to a drain of a second regulator transistor Q2, and an output coupled to a gate of the second regulator transistor Q2. A source of the second regulator transistor Q2 is coupled to a second voltage rail V2, which may be at the same voltage as, or a different voltage from, the first voltage rail V1. The drain of the second regulator transistor Q2 is also coupled to an output 34 of the second power supply stage 30, for delivering a second power P₂ dependent on the second envelope signal E₂.

A second amplification stage (AMP2) 60 is arranged to amplify the input signal Sᵢ using the second power P₂ as a second supply of power dependent on the second envelope signal E₂. The second amplification stage 60 comprises a first input 62 coupled the output 34 of the second power supply stage 30 for receiving the second power P₂. The second amplification stage 60 also comprises a second inductive element L2 coupled between the first input 62 of the second amplification stage 60 and a drain of a second amplification transistor T2. The second amplification transistor T2 has a gate coupled to a second input 64 of the second amplification stage 60, which is coupled to the input 12 of the envelope generation stage 10 for receiving the input signal Sᵢ, and a source coupled the reference voltage rail V₀. The drain of the second amplification transistor T2 is coupled to an output 66 of the second amplification stage 60 for delivering the input signal Sᵢ amplified by the second amplification stage 60.

A summing stage 80 has a first input 82 coupled to the output 56 of the first amplification stage 50 and a second input 84 coupled to the output 66 of the second amplification stage 60. The summing stage 80 is arranged to generate an output signal Sₒ at an output 88 of the summing stage 80 by summing the input signal Sᵢ amplified by the first amplification stage 50 and the input signal Sᵢ amplified by the second amplification stage 60. The summing stage 80 comprises a first reactive element X1 coupled between the first input 82 of the summing stage 80 and the output 88 of the summing stage 80, a second reactive element X2 coupled between the second input 84 of the summing stage 80 and the output 88 of the summing stage 80, and a fourth reactive element X4 coupled between the output 88 of the summing stage 80 and the reference voltage rail V0. As illustrated in the example of Figure 1, the first and second reactive elements X1, X2 may be inductive elements, in which case the fourth reactive element X4 is a capacitive element. Alternatively, the first and second reactive elements X1, X2 may be capacitive elements, in which case the fourth reactive element X4 is an inductive element.

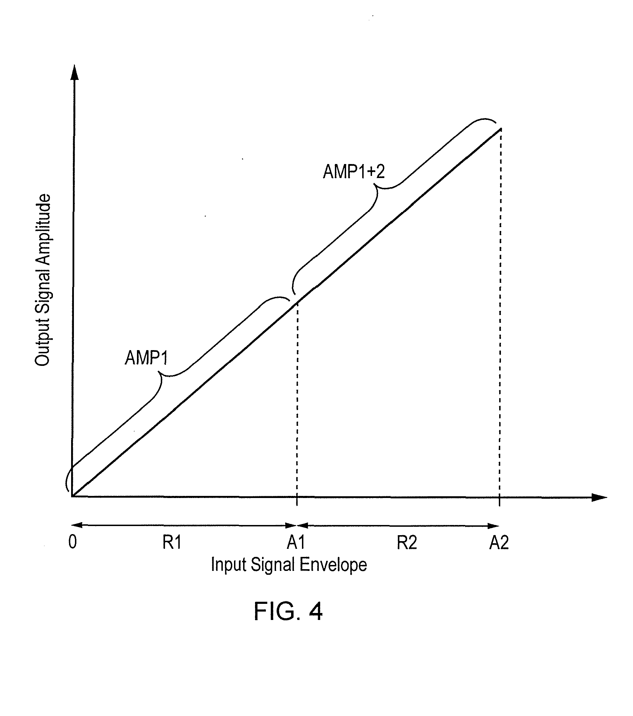

In operation, when the envelope of the input signal Sᵢ is in the first range R1, 0<R1≤A1, the first envelope signal E₁ is related linearly to the envelope of the input signal Sᵢ, and therefore the first power P₁ may also be related linearly to the envelope of the input signal Sᵢ and the first amplification stage 50 operates in an envelope tracking mode and delivers the amplified input signal Sᵢ to the summing stage 80. When the envelope of the input signal Sᵢ is in the first range R1, the second envelope signal E₂ is independent of the envelope of the input signal Sᵢ, at zero or a low level, and therefore the second power P₂ is also zero or at a low level sufficient for biasing the second amplification transistor T2, and the second amplification stage 60 does not deliver the amplified input signal Sᵢ to the summing stage 80. Therefore, when the envelope of the input signal Sᵢ is in the first range R1, only the first amplification stage 50 amplifies the input signal Sᵢ and contributes to the output signal Sₒ, as illustrated in Figure 4.

When the envelope of the input signal Sᵢ is in the second range R2 , A1 <R2≤A2, the first envelope signal E₁ is independent the envelope of the input signal Sᵢ, and therefore the first power P₁ is also independent the envelope of the input signal Sᵢ and the first amplification stage 50 does not operate in an envelope tracking mode but in a constant power supply mode, and delivers the amplified input signal Sᵢ to the summing stage 80. When the envelope of the input signal Sᵢ is in the second range R2, the second envelope signal E₂ is related linearly to the envelope of the input signal Sᵢ, and therefore the second power P₂ may also be related linearly to the envelope of the input signal Sᵢ and the second amplification stage 60 operates in an envelope tracking mode and delivers the amplified input signal Sᵢ to the summing stage 80. Therefore, when the envelope of the input signal Sᵢ is in the second range R2, both the first and second amplification stages 50, 60 amplify the input signal Sᵢ and contribute to the output signal Sₒ, as illustrated in Figure 4.

The power efficiency of the amplifier 100 described with reference to Figure 1 is high because, when the envelope of the input signal Sᵢ is in the first range R1, the second amplification stage 60 does not amplify the input signal Sᵢ and therefore has a low power consumption, and when the envelope of the input signal Sᵢ is in the second range R2, the first amplification stage 50 operates at, or close to, its peak power level where its power efficiency is highest.

An amplifier according to the present disclosure is not limited to having only the first and second amplification stages 50, 60, but can have a plurality of amplification stages greater than two.

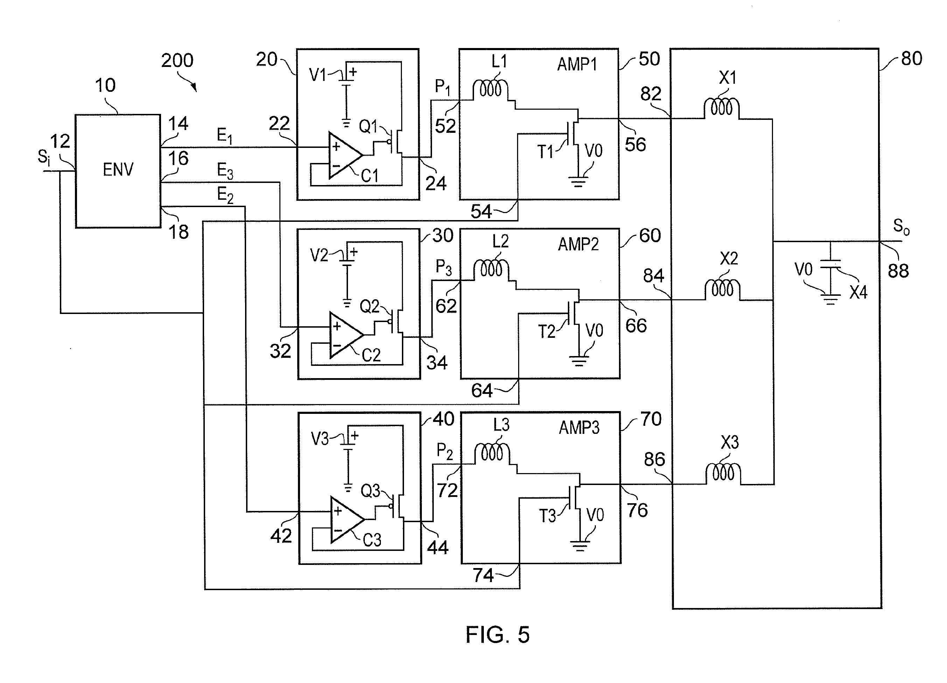

Referring to Figure 5, an amplifier 200 comprises all the elements of the amplifier 100 described with reference to Figure1, operable in the manner described above, and so these elements are not described again. The envelope generation stage 10 of the amplifier 200 is further arranged to generate a third envelope signal E₃ in response to the input signal Sᵢ which it delivers at a third output 18 of the envelope generator 10. Furthermore, the first, second and third envelope signals E₁, E₂, E₃ are characterised over three ranges of values of the envelope of the input signal Sᵢ.

In the amplifier 200, the first envelope signal E₁ is related linearly to the envelope of the input signal Sᵢ over the first range of values R1, 0<R1≤A1, of the envelope of the input signal, and is substantially independent of the envelope of the input signal Sᵢ over the second range R2, A1 <R2≤A2, of values of the envelope of the input signal Sᵢ, as described with reference to Figure 2, and also over a third range R3, A2<R3≤A3, of values of the envelope of the input signal Sᵢ, where the third range R3 is higher than the first and second ranges R1, R2. In particular, the first envelope signal E₁ may be constant at the value E₁ₘₐₓ, or a lower value, over the second and third ranges R2, R3. Preferably, over the second and third ranges R2, R3, the first envelope signal E₁ exceeds ninety percent of the value E₁ₘₐₓ. Also, preferably over the second and third ranges R2, R3, the first envelope signal E₁ is substantially constant. The third range R3 is greater than the value A2, and less than or equal to a value A3.

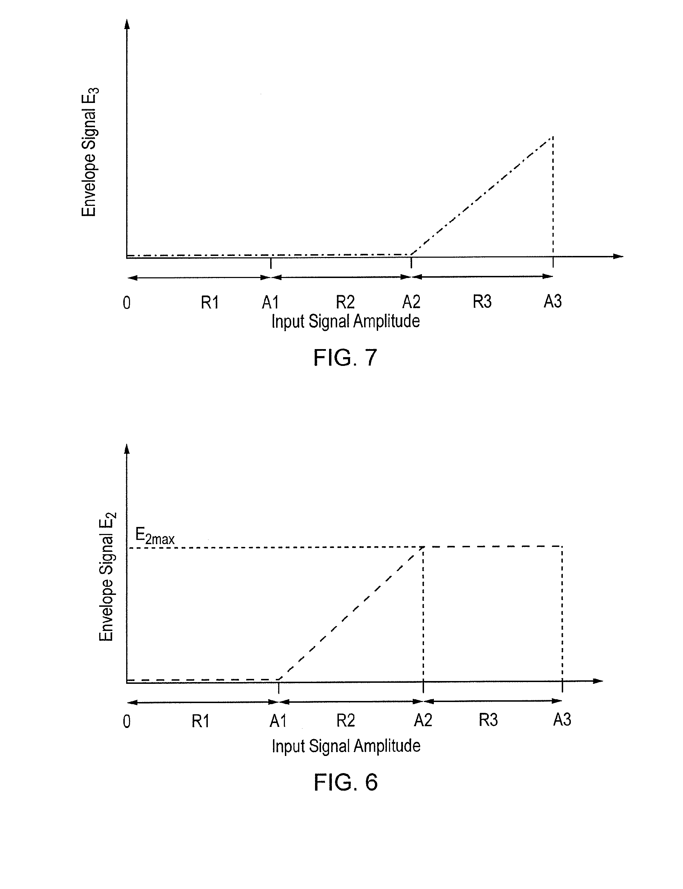

Referring to Figure 6, the second envelope signal E₂ is substantially independent of the envelope of the input signal Sᵢ over the first range R1 of values of the input signal envelope, and is related linearly to the envelope of the input signal Sᵢ over the second range R2 of values of the envelope of the input signal Sᵢ, as described above with reference to Figure 3. Over the third range R3, A2<R3≤A3 of values of the envelope of the input signal Sᵢ, the second envelope signal E₂ is substantially independent of the envelope of the input signal Sᵢ. Preferably, over the third range R3 of values of the input signal envelope the second envelope signal E₂ may be constant at the value E₂ₘₐₓ, as illustrated in the example of Figure 6, where E₂ₘₐₓ is the maximum value of the second envelope signal E₂, but in other examples the second envelope signal E₂ may have a lower value than E₂ₘₐₓ over the third range. Preferably , over the third range R3 of values of the input signal envelope, the second envelope signal E₂ exceeds ninety percent of the value E₂ₘₐₓ. Also, preferably over the third range R3 of values of the input signal envelope, the second envelope signal E₂ is substantially constant. The maximum value, E₂ₘₐₓ, of the second envelope signal E₂ may be the same as, or different from the maximum value, E₁ₘₐₓ, of the first envelope signal E_{1.}

Referring to Figure 7, the third envelope signal E₃ is substantially independent of the envelope of the input signal Sᵢ over the first and second ranges R1, R2 of values of the envelope of the input signal Sᵢ, and is related linearly to the envelope of the input signal Sᵢ over the third range R3 of values of the envelope of the input signal Sᵢ. Over the first and second ranges R1, R2, the third envelope signal E₃ may be zero, or may have a low value, typically sufficient for ensuring biasing of a third amplification stage, referenced 70 in Figure 5 and described below. Furthermore, the third envelope signal E₃ may be zero when the input signal envelope has a value at the lowest end of the third range R3, but alternatively may have a low non-zero value, typically sufficient for ensuring biasing of the third amplification stage 70, as in the first and second ranges R1, R2. In particular, over the first and second ranges R1, R2 the third envelope signal E₃ may have a value less than ten percent of a maximum value E₃ₘₐₓ of the third envelope signal E₃, where E₃ₘₐₓ is a maximum value of the third envelope signal E₃ that is, or can be, provided. Also, preferably over the first and second ranges R1, R2 of values of the input signal envelope the third envelope signal E₃ is substantially constant.

Reverting to Figure 5, the third output 18 of the envelope generation stage 10 is coupled to an input 42 of a third power supply stage 40 which may be a voltage regulator, as illustrated in Figure 5, but alternatively may be a current regulator. In the example of Figure 5, the third power supply stage 40 is a voltage regulator and comprises a third comparator C3 having a non-inverting input coupled to the input 42 of the third power supply stage 40, an inverting input coupled to a drain of a third regulator transistor Q3, and an output coupled to a gate of the third regulator transistor Q3. A source of the third regulator transistor Q3 is coupled to a third voltage rail V3, which may be at the same voltage as, or a different voltage from, the first or second voltage rails V1, V2. The drain of the third regulator transistor Q3 is also coupled to an output 44 of the third power supply stage 40, for delivering a third power P₃ dependent on the third envelope signal E₃.

A third amplification stage (AMP3) 70 is arranged to amplify the input signal Sᵢ using the third power P₃ as a third supply of power dependent on the third envelope signal E₃. The third amplification stage 70 comprises a first input 72 coupled the output 44 of the third power supply stage 40 for receiving the third power P₃. The third amplification stage 70 also comprises a third inductive element L3 coupled between the first input 72 of the third amplification stage 70 and a drain of a third amplification transistor T3. The third amplification transistor T3 has a gate coupled to a second input 74 of the third amplification stage 60, which is coupled to the input 12 of the envelope generation stage 10 for receiving the input signal Sᵢ, and a source coupled the reference voltage rail V0. The drain of the third amplification transistor T3 is coupled to an output 76 of the third amplification stage 70 for delivering the input signal Sᵢ amplified by the third amplification stage 70.

The summing stage 80 of the amplifier 200 has a third input 86 coupled to the output 76 of the third amplification stage 70. The summing stage 80 is arranged to generate an output signal Sₒ at the output 88 of the summing stage 80 by summing the input signal Sᵢ amplified by the first amplification stage 50, the input signal Sᵢ amplified by the second amplification stage 60, and input signal Sᵢ amplified by the third amplification stage 70. The summing stage 80 comprises a third reactive element X3 coupled between the third input 86 of the summing stage 80 and the output 88 of the summing stage 80. As illustrated in the example of Figure 5, the first, second and third reactive elements X1, X2, X3 may be inductive elements, in which case the fourth reactive element X4 is a capacitive element. Alternatively, the first, second and third reactive elements X1, X2, X3 may be capacitive elements, in which case the fourth reactive element X4 is an inductive element.

The first, second and third reactive elements X1, X2, X3 may have a common reactance, or alternatively may have different reactance in order to tune an output impedance at the output 88 of the summing stage 80 to ensure efficient transfer of power to a load coupled to the output 88 of the summing stage 80, across each range of values of the envelope of the input signal Sᵢ.

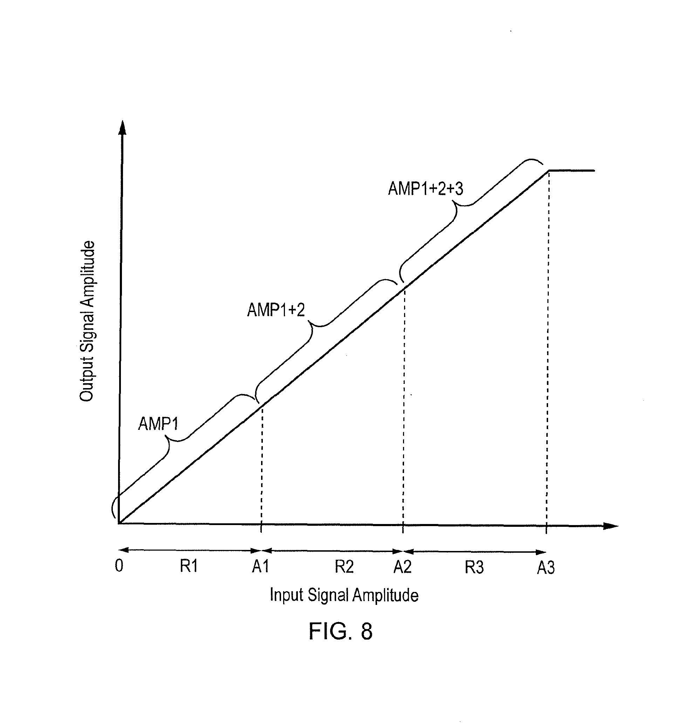

In operation, when the envelope of the input signal Sᵢ is in the first range R1, the first envelope signal E₁ is related linearly to the envelope of the input signal Sᵢ, and therefore the first power P₁ is also related linearly to the envelope of the input signal Sᵢ and the first amplification stage 50 operates in an envelope tracking mode and delivers the amplified input signal Sᵢ to the summing stage 80. When the envelope of the input signal Sᵢ is in the first range R1, the second and third envelope signals E₂, E₃ are both independent of the envelope of the input signal Sᵢ, at zero or a low level, and therefore the second and third powers P₂, P₃ are also zero or at a low level sufficient for biasing the second and third amplification transistors T2, T3, and the second and third amplification stages 60, 70 do not deliver the amplified input signal Sᵢ to the summing stage 80. Therefore, when the envelope of the input signal Sᵢ is in the first range R1, only the first amplification stage 50 amplifies the input signal Sᵢ and contributes to the output signal Sₒ, as illustrated in Figure 8.

When the envelope of the input signal Sᵢ is in the second range R2, the first envelope signal E₁ is independent the envelope of the input signal Sᵢ, and therefore the first power P₁ is also independent the envelope of the input signal Sᵢ and the first amplification stage 50 does not operate in an envelope tracking mode but in a constant power supply mode, and delivers the amplified input signal Sᵢ to the summing stage 80. When the envelope of the input signal Sᵢ is in the second range R2, the second envelope signal E₂ is related linearly to the envelope of the input signal Sᵢ, and therefore the second power P₂ is also related linearly to the envelope of the input signal Sᵢ and the second amplification stage 60 operates in an envelope tracking mode and delivers the amplified input signal Sᵢ to the summing stage 80. Also, when the envelope of the input signal Sᵢ is in the second range R2, the third envelope signal E₃ is independent of the envelope of the input signal Sᵢ, at zero or a low level, and therefore the third power P₃ is also zero or at a low level, and the third amplification stage 70 does not deliver the amplified input signal Sᵢ to the summing stage 80. Therefore, when the envelope of the input signal Sᵢ is in the second range R2, only the first and second amplification stages 50, 60 amplify the input signal Sᵢ and contribute to the output signal Sₒ, as illustrated in Figure 8.

When the envelope of the input signal Sᵢ is in the third range R3, A2<R3≤A3, the first and second envelope signals E₁, E₂ are both independent the envelope of the input signal Sᵢ, and therefore the first and second powers P₁, P₂ are also independent the envelope of the input signal Sᵢ and the first and second amplification stages 50, 60 do not operate in an envelope tracking mode but in a constant power supply mode, and both deliver the amplified input signal Sᵢ to the summing stage 80. When the envelope of the input signal Sᵢ is in the third range R3, the third envelope signal E₃ is related linearly to the envelope of the input signal Sᵢ, and therefore the third power P₃ is also related linearly to the envelope of the input signal Sᵢ and the third amplification stage 70 operates in an envelope tracking mode and delivers the amplified input signal Sᵢ to the summing stage 80. Therefore, when the envelope of the input signal Sᵢ is in the third range R3, the first, second and third amplification stages 50, 60, 70 amplify the input signal Sᵢ and each contribute to the output signal Sₒ, as illustrated in Figure 8. When the envelope of the input signal Sᵢ exceeds A3, the third amplification stage 70 may saturate, in which case the amplification it provides can cease to be linear, and the amplified input signal that it delivers to the summing stage 80 can cease to be linearly related to the input signal Sᵢ, as illustrated in Figure 8 where the envelope of the input signal Sᵢ exceeds A3.

The power efficiency of the amplifier 200 described with reference to Figure 5 is high because, when the envelope of the input signal Sᵢ is in the first range R1, the second and third amplification stages 60, 70 do not amplify the input signal Sᵢ and therefore have a low power consumption, when the envelope of the input signal Sᵢ is in the second range R2, the first amplification stage 50 is operating at, or close to, its peak power level where its power efficiency is highest, and the third amplification stage 70 does not amplify the input signal Sᵢ and therefore has a low power consumption, and when the envelope of the input signal Sᵢ is in the third range R3, the first and second amplification stages 50, 60 operate at, or close to, their respective peak power levels where their power efficiency is highest.

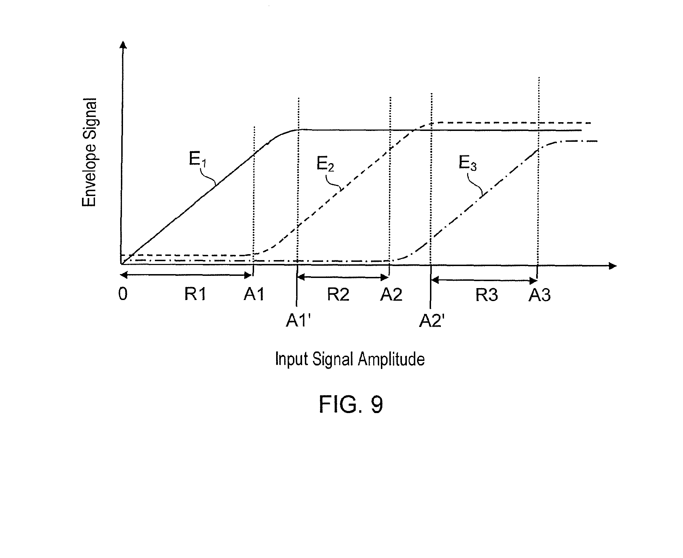

In the examples described above, the first and second ranges R1, R2 are contiguous, and the second and third ranges R2, R3 are contiguous, such that there is no gap between the first and second ranges R1, R2, and no gap between the second and third ranges R2, R3. In other embodiments these ranges may not be contiguous. Figure 9 illustrates the first, second and third envelope signals E₁, E₂, E₃ for such an embodiment. Referring to Figure 9, the first range R1 extends from zero to an amplitude A1 of the envelope of the input signal Sᵢ, the second range R2 extends from an amplitude A1' to A2, and the third range R3 extends from an amplitude A2' to A3. There is a first gap between the first and second ranges R1, R2, corresponding to values of the envelope of the input signal Sᵢ between A1 and A1', and a second gap between the second and third ranges R2, R3, corresponding to values of the envelope of the input signal Sᵢ between A2 and A2'.

In the first gap, the first envelope signal E₁ is in a first transition from being related linearly to the envelope of the input signal Sᵢ over the first range R1, to being substantially independent of the envelope of the input signal Sᵢ in the second range R2. Alternatively, or additionally, in the first gap the first amplification stage 50 may enter compression as the envelope of the input signal Sᵢ increases.

Similarly, in the second gap, the second envelope signal E₂ is in a second transition from being related linearly to the envelope of the input signal Sᵢ over the second range R2, to being substantially independent of the envelope of the input signal Sᵢ in the third range R3. Alternatively, or additionally, in the second gap the second amplification stage 60 may enter compression, as the envelope of the input signal Sᵢ increases.

Also, in the first gap, the second envelope signal E₂ is in a third transition from being substantially independent the envelope of the input signal Sᵢ in the first range R1, to being related linearly to the envelope of the input signal Sᵢ over the second range R2. Alternatively, or additionally, in the first gap the second amplification stage 60 may switch on, as the envelope of the input signal Sᵢ increases.

Likewise, in the second gap, the third envelope signal E₃ is in a fourth transition from being substantially independent the envelope of the input signal Sᵢ in the first and second ranges R1, R2, to being related linearly to the envelope of the input signal Sᵢ over the third range R3. Alternatively, or additionally, in the second gap the third amplification stage 70 may switch on, as the envelope of the input signal Sᵢ increases.

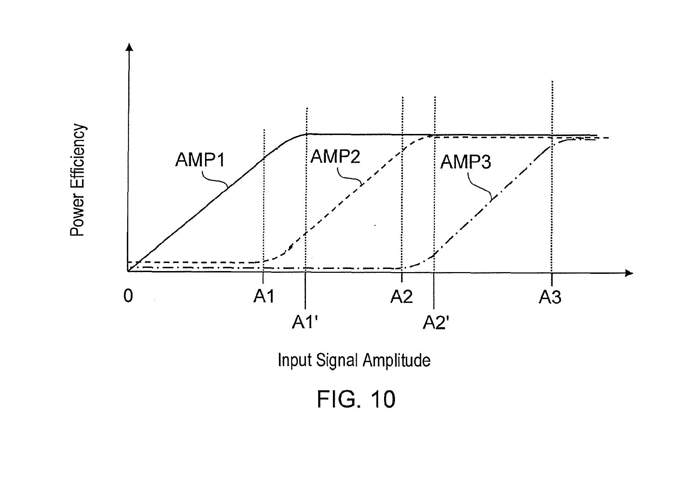

Referring to Figure 10, the power efficiency of the first, second and third amplification stages 50, 60, 70 is illustrated as a function of the envelope of the input signal Sᵢ corresponding to the first, second and third envelope signals E₁, E₂, E₃ described with reference to Figure 9. In the first range R1, the power efficiency of the first amplification stage (AMP1) 50 increases as the envelope of the input signal Sᵢ increases, and reaches a maximum value in the second range R2. In the second range R2, the power efficiency of the second amplification stage (AMP2) 60 increases as the envelope of the input signal Sᵢ increases further, and reaches a maximum value in the third range R3. In the third range R3, the power efficiency of the third amplification stage (AMP3) 70 increases as the envelope of the input signal Sᵢ increases further, and reaches a maximum value above the third range R3 where it saturates. In the first range R1, the second and third amplification stages 60, 70 have low efficiency, but consume little power as they are not amplifying the input signal Sᵢ. Similarly, in the second range R2, the third amplification stage 70 has low efficiency, but consumes little power as it not amplifying the input signal Sᵢ. The overall power efficiency of the amplifier 200 is the combined effect of the efficiency of the first, second and third amplification stages 50, 60, 70.

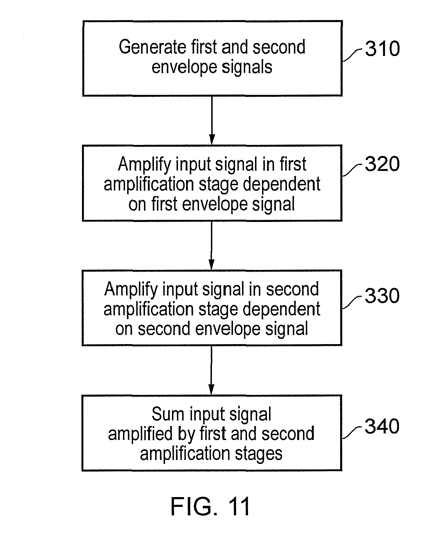

Referring to Figure 11, a method of amplification comprises, at step 310, generating the first and second envelope signals E₁, E₂ in response to the input signal Sᵢ, where the first and second envelope signals E₁, E₂ have the characteristics described above. At step 320, the input signal Sᵢ is amplified, dependent on the first envelope signal E₁, in the first amplification stage 50 whilst supplying to the first amplification stage 50 first power P₁ dependent on the first envelope signal E₁. At step 330, the input signal Sᵢ is amplified, dependent on the second envelope signal E₂, in the second amplification stage 60 whilst supplying to the second amplification stage 60 second power P₂ dependent on the second envelope signal E₂. At step 340, the input signal Sᵢ amplified by the first amplification stage 50 and the input signal Sᵢ amplified by the second amplification stage 60 are summed.

Preferably, the first power P₁ is dependent on the first envelope signal E₁ by being related linearly to the first envelope signal E₁ over the first range R1. This is appropriate if the first envelope signal E₁ is related linearly to the envelope of the input signal Sᵢ over the first range R1, as illustrated in Figure 2, and will enable the first power P₁ to be related linearly to the envelope of the input signal Sᵢ over the first range R1. However, this is not essential and, in other embodiments, alternatively the first power P₁ may be dependent on the first envelope signal E₁ in a non-linear manner, for example for ease of implementation, in which case the first envelope signal E₁ may be related in a complementary non-linear manner to the envelope of the input signal Sᵢ over the first range R1, such that the combined effect of these two non-linear relationships is a linear, or close to linear, relationship between the first power P₁ and the envelope of the input signal Sᵢ over the first range R1. In this case, the non-linear relationship between the first envelope signal E₁ and the envelope of the input signal Sᵢ over the first range R1 provides, in effect, pre-distortion to compensate for the non-linear relationship between the first envelope signal E₁ and the first power P₁. Therefore, the first envelope signal E₁ is indicative of the envelope of the input signal Sᵢ, either in a linear or non-linear manner.

Likewise, preferably the second power P₂ is dependent on the second envelope signal E₂ by being related linearly to the second envelope signal E₂ over the second range R2. This is appropriate if the second envelope signal E₂ is related linearly to the envelope of the input signal Sᵢ over the second range R2, as illustrated in Figures 3 and 6, and will enable the second power P₂ to be related linearly to the envelope of the input signal Sᵢ over the second range R2. However, this is not essential and, in other embodiments, alternatively the second power P₂ may be dependent on the second envelope signal E₂ in a non-linear manner, for example for ease of implementation, in which case the second envelope signal E₂ may be related in a complementary non-linear manner to the envelope of the input signal Sᵢ over the second range R2, such that the combined effect of these two non-linear relationships is a linear, or close to linear, relationship between the second power P₂ and the envelope of the input signal Sᵢ over the second range R2. In this case, the non-linear relationship between the second envelope signal E₂ and the envelope of the input signal Sᵢ over the second range R2 provides, in effect, pre-distortion to compensate for the non-linear relationship between the second envelope signal E₂ and the second power P₂. Therefore, the second envelope signal E₂ is indicative of the envelope of the input signal Sᵢ, either in a linear or non-linear manner.

Likewise, in the embodiment described with reference to Figure 5, preferably the third power P₃ is dependent on the third envelope signal E₃ by being related linearly to the third envelope signal E₃ over the third range R3. This is appropriate if the third envelope signal E₃ is related linearly to the envelope of the input signal Sᵢ over the third range R3, as illustrated in Figure 7, and will enable the third power P₃ to be related linearly to the envelope of the input signal Sᵢ over the third range R3. However, this is not essential and, in other embodiments, alternatively the third power P₃ may be dependent on the third envelope signal E₃ in a non-linear manner, for example for ease of implementation, in which case the third envelope signal E₃ may be related in a complementary non-linear manner to the envelope of the input signal Sᵢ over the third range R3, such that the combined effect of these two non-linear relationships is a linear, or close to linear, relationship between the third power P₃ and the envelope of the input signal Sᵢ over the third range R3. In this case, the non-linear relationship between the third envelope signal E₃ and the envelope of the input signal Sᵢ over the third range R3 provides, in effect, pre-distortion to compensate for the non-linear relationship between the third envelope signal E₃ and the third power P₃. Therefore, the third envelope signal E₃ is indicative of the envelope of the input signal Sᵢ, either in a linear or non-linear manner.

Typically, the input signal Sᵢ is an amplitude modulated carrier signal, and the envelope generation stage 10 may determine the envelope of the input signal Sᵢ by determining the amplitude modulation of the carrier signal, and from the determined envelope of the input signal Sᵢ determine the first, second and third envelope signals E₁, E₂, E₃ in accordance with the characteristics described herein. In other embodiments of the amplifier 100, 200, the envelope generation stage 10 may be provided with a modulation signal, for example from a modem or modulation generator, indicative of the amplitude modulation of the carrier signal, and from the provided modulation signal determine the first, second and third envelope signals E₁, E₂, E₃ in accordance with the characteristics described herein.

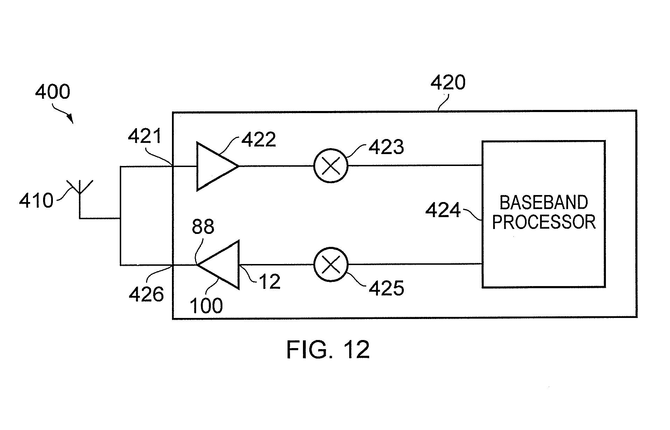

Referring to Figure 12, a wireless communication device 400 comprises an antenna 410 coupled to an input 421 of an electronic device 420, which may be, for example, an integrated circuit, and coupled to an output 426 of the electronic device 420. The electronic device 420 comprises a low noise amplifier 422 having an input coupled to the input 421 of the electronic device 420 for amplifying received signals received at the antenna 410. An output of the low noise amplifier 422 is coupled to an input of a downconversion stage 423 for down-converting, from a radio frequency to a lower frequency, the received signals amplified by the low noise amplifier 422. An output of the downconversion stage 423 is coupled to an input of a baseband processor 424 for processing the down-converted signals by, for example, equalising, demodulating and decoding. An output of the baseband processor 424 is coupled to an input of an up-conversion stage 425 for up-converting, from a baseband frequency to a radio frequency, signals to be transmitted. An output of the up-conversion stage 425 is coupled to the input 12 of the envelope generation stage 10 of the amplifier 100 described with reference to Figure 1, for amplifying the radio frequency signals to be transmitted. The output 88 of the summing stage 80 of the amplifier 100 is coupled to the output 426 of the electronic device 420, for delivering the amplified signals to the antenna for emission.

The electronic device 420 described with reference to Figure 12 is one example of an electronic device that comprises the amplifier 100 described with reference to Figure 1, or alternatively may comprise the amplifier 200 described with reference to Figure 5.

Other variations and modifications will be apparent to the skilled person. Such variations and modifications may involve equivalent and other features which are already known and which may be used instead of, or in addition to, features described herein. Features that are described in the context of separate embodiments may be provided in combination in a single embodiment. Conversely, features which are described in the context of a single embodiment may also be provided separately or in any suitable subcombination.

It should be noted that the term "comprising" does not exclude other elements or steps, the term "a" or "an" does not exclude a plurality, a single feature may fulfil the functions of several features recited in the claims and reference signs in the claims shall not be construed as limiting the scope of the claims. It should also be noted that the Figures are not necessarily to scale; emphasis instead generally being placed upon illustrating the principles of the present invention.

## Claims

1. An amplifier (200) comprising:
an envelope generation stage (10) arranged to generate first and second envelope signals in response to an input signal;
wherein the first envelope signal is indicative of an envelope of the input signal over a first range of values of the envelope of the input signal and is substantially independent of the envelope of the input signal over a second range, higher than the first range, of values of the envelope of the input signal;
wherein the second envelope signal is indicative of the envelope of the input signal over the second range of values of the envelope of the input signal and is substantially independent of the envelope of the input signal over the first range of values of the envelope of the input signal;
a first amplification stage (50) arranged to amplify the input signal and having a first supply of power dependent on the first envelope signal;
a second amplification stage (60) arranged to amplify the input signal and having a second supply of power dependent on the second envelope signal; and
a summing stage (80) arranged to sum the input signal amplified by the first and second amplification stages (50, 60).

2. An amplifier (200) as claimed in claim 1, wherein the first envelope signal is related linearly to the envelope of the input signal over the first range.

3. An amplifier (200) as claimed in claim 1 or claim 2, wherein, over the second range, the first envelope signal exceeds ninety percent of a maximum value of the first envelope signal.

4. An amplifier (200) as claimed in any preceding claim, wherein and the second envelope signal is related linearly to the envelope of the input signal over the second range.

5. An amplifier (200) as claimed in any preceding claim, wherein, over the first range, the second envelope signal is less than ten percent of a maximum value of the second envelope signal.

6. An amplifier (200) as claimed in any preceding claim, wherein the first and second ranges of values of the envelope of the input signal are spaced apart by a first gap of width less than ten percent of the first range.

7. An amplifier (200) as claimed in any preceding claim:
wherein the envelope generation stage (80) is arranged to generate a third envelope signal in response to the input signal;
wherein the third envelope signal is indicative of the envelope of the input signal over a third range, higher than the second range, of values of the envelope of the input signal and is substantially independent of the envelope of the input signal over the first and second ranges of values of the envelope of the input signal;
wherein the first and second envelope signals are substantially independent of the envelope of the input signal over the third range;
comprising a third amplification stage (70) arranged to amplify the input signal and having a third supply of power dependent on the third envelope signal; and
wherein the summing stage (80) is arranged to sum the input signal amplified by the first, second and third amplification stages (50, 60, 70).

8. An amplifier (200) as claimed in claim 7, wherein the third envelope signal is related linearly to the envelope of the input signal over the third range.

9. An amplifier (200) as claimed in claim 7 or 8, wherein, over the third range, the first envelope signal exceeds ninety percent of a/the maximum value of the first envelope signal and the second envelope signal exceeds ninety percent of a/the maximum value of the second envelope signal.

10. An amplifier (200) as claimed in any one of claims 7 to 9, wherein, over the first and second ranges, the third envelope signal is less than ten percent of a maximum value of the third envelope signal.

11. An amplifier (200) as claimed in any one of claims 7 to 10, wherein the second and third ranges of values of the envelope of the input signal are spaced apart by a second gap of width less than ten percent of the second range.

12. An electronic device (420) comprising an amplifier (200) as claimed in any preceding claim.

13. A mobile communication device (400) comprising an amplifier (200) as claimed in any one of claims 1 to 11.

14. A method of amplification, comprising:
generating first and second envelope signals in response to an input signal;
wherein the first envelope signal is indicative of an envelope of the input signal over a first range of values of the envelope of the input signal and is substantially independent of the envelope of the input signal over a second range, higher than the first range, of values of the envelope of the input signal;
wherein the second envelope signal is indicative of the envelope of the input signal over the second range of values of the envelope of the input signal and is substantially independent of the envelope of the input signal over the first range of values of the envelope of the input signal;
amplifying, dependent on the first envelope signal, the input signal in a first amplification stage (50) whilst supplying to the first amplification stage (50) first power dependent on the first envelope signal;
amplifying, dependent on the second envelope signal, the input signal in a second amplification stage (60) whilst supplying to the second amplification stage (60) second power dependent on the second envelope signal; and
summing the input signal amplified by the first and second amplification stages (50, 60).

15. A method of amplification as claimed in claim 14, comprising:
generating a third envelope signal in response to the input signal;
wherein the third envelope signal is indicative of the envelope of the input signal over a third range, higher than the second range, of values of the envelope of the input signal and is substantially independent of the envelope of the input signal over the first and second ranges of values of the envelope of the input signal;
wherein the first and second envelope signals are substantially independent of the envelope of the input signal over the third range;
amplifying, dependent on the third envelope signal, the input signal in a third amplification stage (70) whilst supplying to the third amplification stage (70) third power dependent on the third envelope signal; and
summing the input signal amplified by the first, second and third amplification stages (50, 60, 70).
